# EUROPEAN PATENT SPECIFICATION

(11) **EP 1 820 379 B1**
(45) Date of publication and mention of the grant of the patent: **31.10.2012**
(21) Application number: 05820868.7
(22) Date of filing: 03.11.2005
(51) Int. Cl.: H05K 1/16

(54) **COMMUNICATIONS JACK WITH PRINTED WIRING BOARD HAVING SELF-COUPLING CONDUCTORS**
KOMMUNIKATIONSSTECKER MIT LEITERPLATTE MIT SELBSTKOPPELNDEN LEITERN
JACK DE COMMUNICATION AVEC CIRCUIT IMPRIME EQUIPE DE CONDUCTEURS A AUTO-INDUCTION

(30) Priority: 07.12.2004 US 633783 P; 16.12.2004 US 636590 P; 16.12.2004 US 636595 P; 28.01.2005 US 648002 P
(43) Date of publication of application: 22.08.2007
(73) Proprietor: COMMSCOPE INC. OF NORTH CAROLINA, Hickory, North Carolina 28601 (US)
(72) Inventor: HASHIM, Amid, Plano, Texas 75093 (US)
(74) Representative: Popp, Eugen
(86) International application number: PCT/US2005/039586
(87) International publication number: WO 2006/062629

(56) References cited:
- US-A- 5 997 358
- US-B1- 6 170 154
- US-B1- 6 428 362
- US-B1- 6 811 442

## Description

### Field of the Invention

The present invention relates generally to communication connectors and more particularly to the improvement of return loss in high frequency communication connectors.

### Background of the Invention

In an electrical communication system, it is sometimes advantageous to transmit information signals (video, audio, data) over a pair of wires (hereinafter "wire-pair" or "differential pair") rather than a single wire, wherein the transmitted signal comprises the voltage difference between the wires without regard to the absolute voltages present. Each wire in a wire-pair is susceptible to picking up electrical noise from sources such as lightning, automobile spark plugs and radio stations to name but a few. Because this type of noise is common to both wires within a pair, the differential signal is typically not disturbed. This is a fundamental reason for having closely spaced differential pairs.

Of greater concern, however, is the electrical noise that is picked up from nearby wires or pairs of wires that may extend in the same general direction for some distances and not cancel differentially on the victim pair. This is referred to as crosstalk. Particularly, in a communication system involving networked computers, channels are formed by cascading plugs, jacks and cable segments. In such channels, a modular plug often mates with a modular jack, and the routing of the electrical wires (conductors) within the jack and/or plug also can produce near-end crosstalk (NEXT) (i.e., the crosstalk measured at an input location corresponding to a source at the same location). This crosstalk occurs from closely-positioned wires over a short distance. In all of the above situations, undesirable signals are present on the electrical conductors that can interfere with the information signal. As long as the same noise signal is added to each wire in the wire-pair, the voltage difference between the wires will remain about the same and differential cross-talk does not exist.

U.S. Pat. No. 5,997,358 to Adriaenssens et al. (hereinafter "the'358 patent") describes a two-stage scheme for compensating differential to differential NEXT for a plug-jack combination . Connectors described in the'358 patent can reduce the internal NEXT (original crosstalk) between the electrical wire pairs of a modular plug by adding a fabricated or artificial crosstalk, usually in the jack, at one or more stages, thereby canceling or reducing the overall crosstalk for the plug-jack combination. The fabricated crosstalk is referred to herein as a compensation crosstalk. This idea can often be implemented by twice crossing the path of one of the differential pairs within the connector relative to the path of another differential pair within the connector, thereby providing two stages of NEXT compensation. This scheme can be more efficient at reducing the NEXT than a scheme in which the compensation is added at a single stage, especially when the second and subsequent stages of compensation include a time delay that is selected to account for differences in phase between the offending and compensating crosstalk. This type of arrangement can include capacitive and/or inductive elements that introduce multi-stage crosstalk compensation, and is typically employed in jack lead frames and PWB structures within jacks. These configurations can allow connectors to meet "Category 6" performance standards set forth in ANSI/EIA/TIA 568, which are primary component standards for mated plugs and jacks for transmission frequencies up to 250MHz.

Unfortunately, the introduction of compensatory crosstalk can negatively impact other electrical properties. For example, "return loss" measures the degree to which the input impedance of a plug-jack combination or an unshielded twisted wire pair (UTP) matches 100 ohms. Achieving acceptable return loss performance, particularly on conductor pairs 1 and 3 (as designated in TIA 568B) of an eight conductor jack, can be especially challenging due to the heavy crosstalk compensation typically required by these two pairs. Pair 1 return loss can be further aggravated by high capacitance shunting resulting from the close proximity of its two contact blades (i.e., its "tip" and "ring") in a plug. Reaching an acceptable compromise between crosstalk compensation and return loss can be exceptionally challenging for plugs that are to meet or exceed Category 6 performance parameters, particularly if data transmission speeds of 10 Gb/s over UTP are desired over a frequency range of 1-500 MHz.

### Summary of the Invention

The present invention can address some of the issues raised by prior art connectors. As a first aspect, embodiments of the present invention are directed to a communications connector that comprises: plurality of input terminals, a plurality of output terminals, and a plurality of conductive path that connect respective ones of the plurality of input terminals to respective ones of the plurality of output terminals, where at least one of the conductive paths includes two self-coupling sections that are immediately adjacent to each other and that have the same instantaneous current direction such that the sections self-couple and cause a localized increase in inductance.

### Brief Description of the Figures

**Figure 1** is an exploded perspective view of a communications jack according to embodiments of the present invention.
**Figure 1A** is an enlarged perspective view of a wiring board of the communications jack of **Figure 1****.**
**Figure 2** is a schematic plan view of a wiring board of the jack of **Figure 1****,** with conductors residing on different layers of the wiring board being shown in different shading and/or cross-hatching.
**Figure 3** is an enlarged plan view of a conductor pair of the wiring board of **Figure 2****.**
**Figure 4** is an enlarged plan view of a second conductor pair of the wiring board of **Figure 2****.**
**Figure 5** is a graph plotting return loss as a function of frequency for conventional and experimental jacks.

### Detailed Description of Embodiments of the Invention

The present invention will be described more particularly hereinafter with reference to the accompanying drawings. The invention is not intended to be limited to the illustrated embodiments; rather, these embodiments are intended to fully and completely disclose the invention to those skilled in this art. In the drawings, like numbers refer to like elements throughout. Thicknesses and dimensions of some components may be exaggerated for clarity.

Unless otherwise defined, all technical and scientific terms used herein have the same meaning as commonly understood by one of ordinary skill in the art to which this invention belongs. The terminology used in the description of the invention herein is for the purpose of describing particular embodiments only and is not intended to be limiting of the invention. As used in the description of the invention and the appended claims, the singular forms "a", "an" and "the" are intended to include the plural forms as well, unless the context clearly indicates otherwise. As used herein, the term "and/or" includes any and all combinations of one or more of the associated listed items. Where used, the terms "attached", "connected", "interconnected", "contacting", "mounted" and the like can mean either direct or indirect attachment or contact between elements, unless stated otherwise. Also, where used, the terms "coupled", "induced" and the like can mean nonconductive electrical interaction, either direct or indirect, between elements or different sections of the same element, unless otherwise stated. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

In addition, spatially relative terms, such as "under", "below", "lower", "over", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is inverted, elements described as "under" or "beneath" other elements or features would then be oriented "over" the other elements or features. Thus, the exemplary term "under" can encompass both an orientation of over and under. The device may be otherwise oriented (rotated 90 degrees or at other orientations) and the spatially relative descriptors used herein interpreted accordingly.

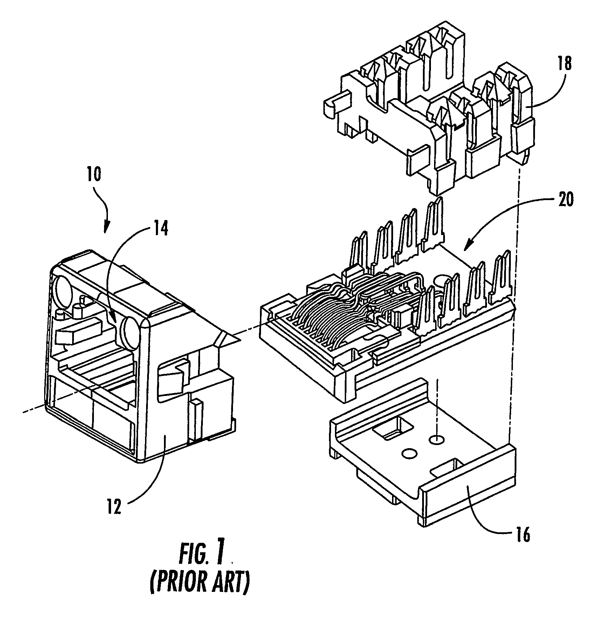

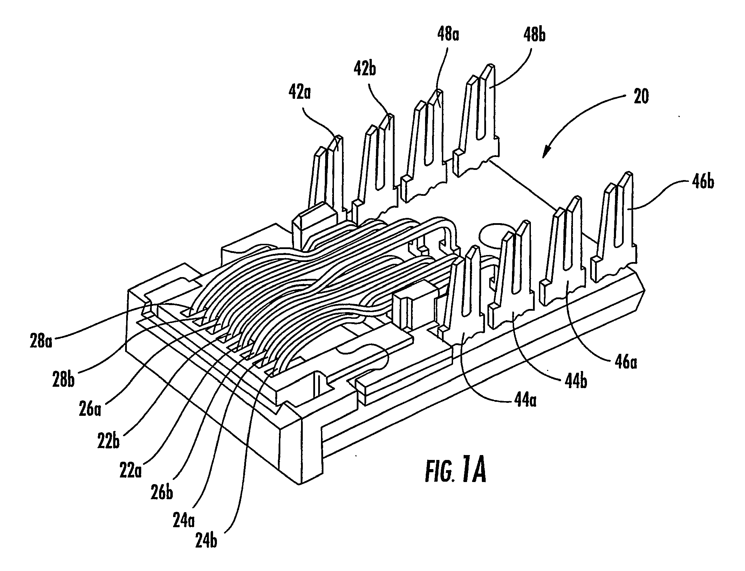

Referring now to the figures, an exemplary communications jack, designated broadly at **10**, is illustrated in **Figure 1****.** The illustrated jack **10** is of the configuration known in this art as an RJ11- or RJ45-style jack. The jack **10** includes a jack frame **12** having a plug aperture **14** for receiving a mating plug (not shown - exemplary plugs are illustrated in U.S. Patent No. 6,250,949 to Lin and in co-pending and co-assigned U.S. Provisional Patent Application Serial No. , filed December 7, 2004 and entitled COMMUNICATION PLUG WITH BALANCED WIRING TO REDUCE DIFFERENTIAL TO COMMON MODE CROSSTALK (Attorney Docket No. 9457-26PR)), a cover **16** and a terminal housing **18.** These components are conventionally formed and not need be described in detail herein; for a further description of these components and the manner in which they interconnect, see U.S. Patent No. 6,350,158 to Arnett et al., Patent No. 6,350,158 to Arnett et al., . Those skilled in this art will recognize that other configurations of jack frames, covers and terminal housings may also be employed with the present invention. Exemplary configurations are illustrated in U.S. Patent Nos. 5,975,919 and 5,947,772 to Arnett et al. and U.S. Patent No. 6,454,541 to Hashim et al., .

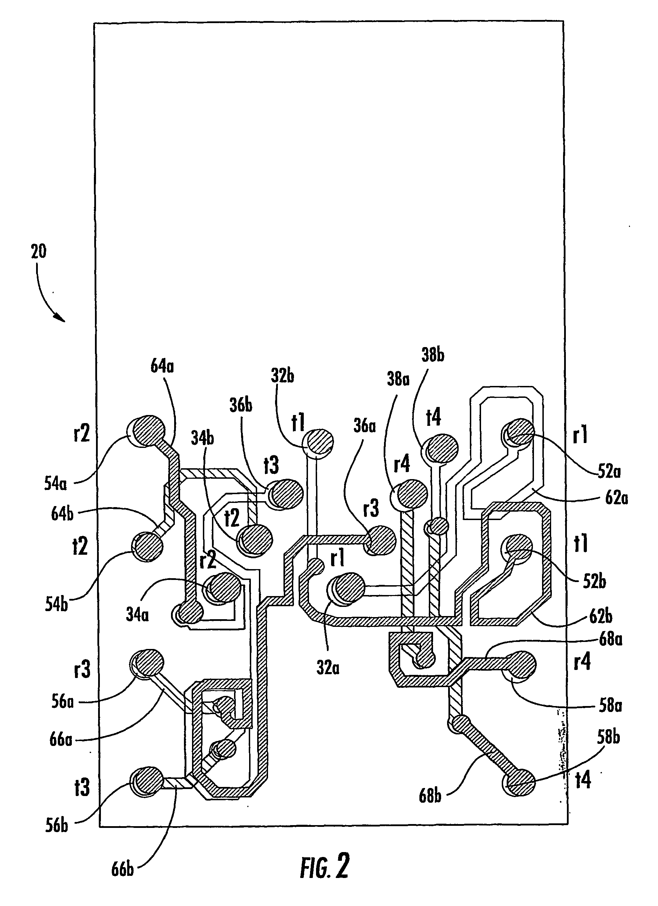

Referring still to **Figure 1** and also to **Figures 1A** and **2****,** the jack **10** further includes a wiring board **20** formed of conventional materials. The wiring board **20** may be a single layer board or, as illustrated, may have multiple layers. The wiring board **20** may be substantially planar as illustrated, or may be non-planar.

Contact wires **22a, 22b, 24a, 24b, 26a, 26b, 28a, 28b** are attached to the wiring board **20.** As described in U.S. Patent No. 6,350,158 referenced above, the contact wires **22a, 22b, 24a, 24b, 26a, 26b, 28a, 28b** have free ends that are disposed generally parallel to each other and that extend into the plug aperture **14** of jack frame **12** to form electrical contact with the terminal blades of a mating plug. The contact wires **22a, 22b, 24a, 24b, 26a, 26b, 28a, 28b** are arranged in pairs defined by TIA 568B, with wires **22a, 22b** (pair 1) being adjacent to each other and in the center of the sequence of wires, wires **24a, 24b** (pair 2) being adjacent to each other and occupying the leftmost two positions (from the vantage point looking from the rear of the jack **10** toward a mating plug in the plug aperture **14)** in the sequence, wires **28a, 28b** (pair 4) being adjacent to each other and occupying the rightmost two positions (again, from the same vantage point as just discussed above) in the sequence, and wires **26a, 26b** (pair 3) being positioned between, respectively, pairs 1 and 4 and pairs 1 and 2. The wires **22a, 22b, 24a, 24b, 26a, 26b, 28a, 28b** are mounted to the wiring board **20** via insertion into respective apertures **32a, 32b, 34a, 34b, 36a, 36b, 38a, 38b,** which are arranged in the illustrated embodiment in a "dual diagonal" pattern as described in U.S. Patent No. 6,196,880 to Goodrich et al., the disclosure of which is hereby incorporated herein in its entirety.

Those skilled in this art will appreciate that contact wires or other contacts of other configurations may be used. As one example, contact wires configured as described in aforementioned U.S. Patent No. 5,975,919 to Arnett et al. may be employed. As another example, contact wires as configured in U.S. Provisional Patent Application No. 60/636,595-, filed December 16, 2004 and entitled CROSSOVER FOR SIMULTANEOUSLY COMPENSATING DIFFERENTIAL TO DIFFERENTIAL OR DIFFERENTIAL TO COMMON MODE CROSSTALK may be employed. The skilled artisan will recognize other suitable alternative configurations.

Eight insulation displacement connectors (IDCs) **42a, 42b, 44a, 44b, 46a, 46b, 48a, 48b** are inserted into eight respective IDC apertures **52a, 52b, 54a, 54b, 56a, 56b, 58a, 58b.** The IDCs may be of conventional construction and need not be described in detail herein; exemplary IDCs are illustrated and described in aforementioned U.S. Patent No. 5,975,919 to Arnett. Connectors other than IDCs may also be employed.

Referring now to **Figure 2****,** the each of the wire apertures **32a, 32b, 34a, 34b, 36a, 36b, 38a, 38b** is electrically connected to a respective IDC aperture **52a, 52b, 54a, 54b, 56a, 56b, 58a, 58b** via a respective conductor **62a, 62b, 64a, 64b, 66a, 66b, 68a, 68b**, thereby interconnecting each of the contact wires **22a, 22b, 24a, 24b, 26a, 26b, 28a, 28b** to its corresponding IDC **42a, 42b, 44a, 44b, 46a, 46b, 48a, 48b.** The conductors **62a, 62b, 64a, 64b, 66a, 66b, 68a, 68b** are formed of conventional conductive materials and are deposited on the wiring board **2**0 via any deposition method known to those skilled in this art to be suitable for the application of conductors. Some conductors are illustrated as being entirely present on a single layer of the wiring board **20** (for example, conductor **62a**), while other conductors (for example, conductor **62b**) may reside on multiple layers of the wiring board **20;** conductors can travel between layers through the inclusion of vias (also known as plated through holes) or other layer-transferring structures known to those skilled in this art.

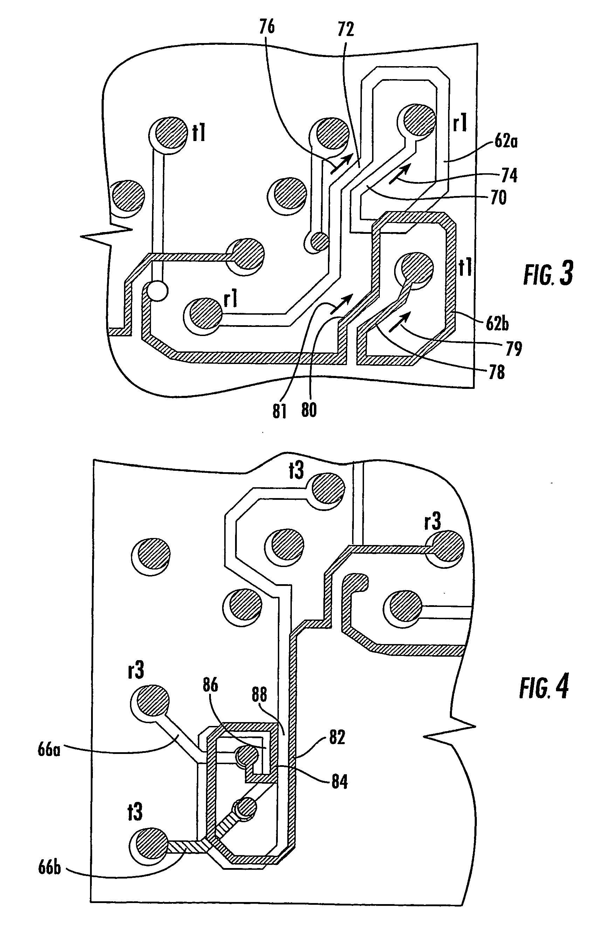

Referring now to **Figure 3****,** it can be seen that conductor **62a,** which connects contact wire **22a** to IDC **42a** (i.e., it connects the "ring" of pair 1) includes sections **70, 72** that are immediately adjacent each other and that, in this embodiment, follow substantially parallel paths. It can also be seen via the arrows **74, 76** that the polarity of the segments is identical, i.e., that the instantaneous current direction (and, thus signal direction) in the segments is the same. The immediate adjacency of this arrangement causes self-coupling between the sections **70, 72** of the conductor **62a,** which in turn triggers an increase in localized inductance. Similarly, conductor **62b,** which connects contact wire **22b** to IDC **42b** (thereby connecting the "tip" of pair 1) includes sections **78, 80** that are immediately adjacent each other and that follow substantially parallel paths with identical instantaneous current direction (*see* arrows **79, 81**). These sections also self-couple and experience an increase in localized inductance.

It has been determined that judicious selection of portions of a conductor that are immediately adjacent each other with identical instantaneous current direction can control the input impedance of a mated plug-jack combination, and, consequently, can control return loss. As such, the jack **10** can withstand the increased crosstalk compensation that may be necessary to achieve, in a mated plug-jack combination, elevated frequency signal transmission while still experiencing acceptable levels of return loss. Typically, conductors of pair 1 that are immediately adjacent to each other for a distance of between about 0.05 and 0.2 inches may be employed, although this distance may vary. The gap between the immediately adjacent segments may be between about 5 to 20 mils; in some embodiments, a minimum gap between adjacent conductors of at least 8 mils is preferred. In a typical jack, causing an increase of between about 2 to 8 nanohenries in localized inductance in pair 1 can provide the desired improvement in return loss (the expected level of inductance can be calculated using, for example, equations set forth in H. Greenhouse, Design of Planar Rectangular Microelectric Inductors, IEEE Transactions on Parts, Hybrids, and Packaging, Vol. PHP-10, No. 2 (June 1974) at page 103).

Referring now to **Figure 4****,** a similar arrangement is illustrated for the conductors **66a, 66b** of pair 3. Conductor **66a** includes sections **82, 84** that are immediately adjacent and substantially parallel with each other with identical signal polarity, and conductor **66b** includes sections **86, 88** that are immediately adjacent and substantially parallel with each other with identical signal polarity. These sections also self-couple and induce localized increases in inductance that can help to control the input impedance of a mated jack-plug combination. Typically, conductors of pair 3 that are immediately adjacent to each other for a distance of between about 0.05 and 0.20 inches may be employed, although this distance may vary. The gap between the immediately adjacent segments may be as described above for pair 1. In a typical jack, causing an increase of between about 2 to 8 nanohenries in localized inductance in pair 3 can provide the desired improvement in return loss.

Typically, and as illustrated, the inclusion of self-coupling sections in conductors of pairs 1 and 3 is sufficient for improving the return loss performance of those pairs; however, this concept can be applied to either of these pairs of conductors alone, and/or to either or both of pairs 2 and 4, or to other conductors of jacks that employ different numbers of conductors (*e.g*., a sixteen conductor jack). Also, although in the illustrated embodiment both of the self-coupling conductors of a wire pair are mounted on the same layer of the wire board, this need not be the case; one or more layers of a wire board may separate the self coupling sections of the conductors. Moreover, the skilled artisan will recognize that many different conductor paths that utilize the concepts of the present invention may be employed.

Those skilled in this art will recognize that embodiments of the wiring board described above may be employed in other environments in which a communications jack may be found. For example, jacks within a patch panel or series of patch panels may be suitable for use with such wiring boards. Other environments may also be possible.

Those skilled in this art will further recognize that the conductor self-coupling sections described above can be implemented, with similar beneficial effect on return loss, by forming the conductor leads of jacks utilizing metallic lead-frame structures instead of printed wiring boards to achieve the required connectivity and crosstalk compensation. In such a configuration, the contact wires and/or the insulation displacement connectors may be formed integrally with the conductors as unitary members.

The invention will now be described in greater detail in the following non-limiting example.

### EXAMPLE

Communications jacks of the configuration illustrated in **Figure 1** were constructed. In one set of jacks, the wiring board included conductors of pair 3 that substantially match that illustrated in **Figure 4****.** In a second set of jacks, the wiring board included conductors that did not have the self-coupling sections. The jacks were then tested for return loss on pair 3 under the conditions set forth in TIA/EIA-568-B.2-1 Annex E.

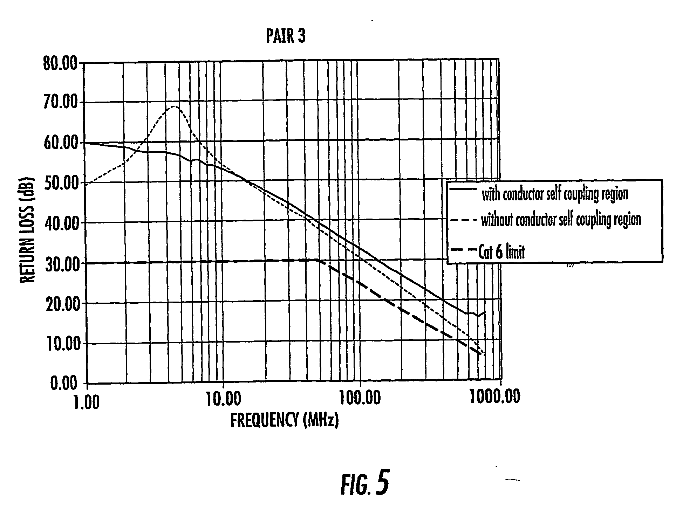

Results of the testing are shown in **Figure 5****.** It can be seen that the experimental jack employing self-coupling conductors exhibited in increase in the return loss decibel level (i.e., an improvement) over the conventional jack, at frequencies above about 15MHz. Furthermore, unlike the conventional jack, the experimental jack did not exhibit deterioration with frequency of its return loss margin relative to the TIA category 6 limit.

The foregoing is illustrative of the present invention and is not to be construed as limiting thereof. Although exemplary embodiments of this invention have been described, those skilled in the art will readily appreciate that many modifications are possible in the exemplary embodiments without materially departing from the novel teachings and advantages of this invention. Accordingly, all such modifications are intended to be included within the scope of this invention as defined in the claims. The invention is defined by the following claims.

## Claims

1. A communications connector (10), comprising:
a plurality of input terminals (22a, 22b; 24a, 24b; 26a, 26b; 28a, 28b); a plurality of output terminals (42a, 42b; 44a, 44b; 46a, 46b; 48a, 48b); and
a plurality of conductive paths (62a, 62b; 64a, 64b; 66a, 66b; 68a, 68b) that connect respective ones of the plurality of input terminals (22a, 22b); (24a, 24b; 26a, 26b; 28a, 28b) to respective ones of the plurality of output terminals (42a, 42b; 44a, 44b; 46a, 46b; 48a, 48b);
wherein at least one of the conductive paths (62a) includes two self-coupling sections (70, 72) that are immediately adjacent to each other and that have the same_instantaneous current direction such that the sections self-couple and cause a localized increase in inductance.

2. The communications connector (10) defined in Claim 1, wherein the connector 10 is a communications jack (10), the jack (10) comprising a jack frame (12) having a plug aperture (14), and wherein the plurality of input terminals (22a, 22b; 24a, 24b; 26a, 26b; 28a, 28b) comprises a plurality of contacts (22a, 22b; 24a, 24b; 26a, 26b; 28a, 28b) that are configure to mate with a respective one of a plurality of plug contacts when a plug is inserted into the plug aperture (14), and wherein the plurality of output terminals (42a, 42b; 44a, 44b; 46a, 46b; 48a, 48b) comprises a plurality of insulation displacement connectors (42a, 42b; 44a, 44b; 46a, 46b; 48a, 48b), and wherein the plurality of conductive paths (62a, 62b; 64a, 64b; 66a, 66b; 68a, 68b) includes a plurality of conductors (62a, 62b; 64a, 64b; 66a, 66b; 68a, 68b) mounted on a dielectric mounting substrate (20), each conductor (62a, 62b; 64a, 64b; 66a, 66b; 68a, 68b) connecting a respective contact (22a, 22b; 24a, 24b; 26a, 26b; 28a, 28b) with a respective insulation displacement connector (42a, 42b; 44a, 44b; 46a, 46b; 48a, 48b), the two self-coupling sections (70, 72) being located on a first one of the plurality of conductors (62a).

3. The communications connector (10) defined in Claim 2, wherein the plurality of conductors (62a, 62b; 64a, 64b; 66a; 66b; 68a, 68b) are configured as differential pairs of conductors, and wherein a second of the plurality of conductors (62b) that together with the first of the plurality of conductors (62a) form a first of the differential pairs includes two self-coupling sections (78, 80) that are immediately adjacent to each other and that have the same instantaneous current direction such that the sections (78, 80) self-couple and cause a localized increase in inductance.

4. The communications connector (10) defined in Claim 3, wherein a third and fourth of the plurality of conductors (66a, 66b) that comprise a second of the differential pairs each include self-coupling sections (82, 84; 86, 88) that are immediately adjacent to each other and that have the same instantaneous current direction such that the sections (82, 84; 86, 88) self-couple and cause a localized increase in inductance.

5. The communications connector (10) defined in Claim 4, wherein the first and second of the plurality of conductors (62a, 62b) are electrically connected to respective first and second of the plurality of contacts (22a, 22b) that have free ends that are adjacent to each other, and wherein the third and fourth of the plurality of conductors (66a, 66b) are electrically connected to respective third and fourth of the plurality of contacts (26a, 26b) that have free ends that sandwich the free ends of the first and second of the plurality of contacts (22a, 22b).

6. The communications connector (10) defined in Claim 2, wherein the self-coupling sections (70, 72) travel immediately adjacent to each other for between about 0.05 and about 0.20 inches.

7. The communications connector (10) defined in Claim 2, wherein a gap between the self-coupling sections (70, 72) is between about 8 and about 15 mils.

8. The communications connector (10) defined in Claim 2, wherein the self-coupling sections (70, 72) cause a localized increase in inductance of between about 2 and about 8 nanohenries.

9. The communications connector (10) defined in Claim 2, wherein the two self-coupling sections (70, 72) of the first of the plurality of conductors 62a are adjacent one of the plurality of mounting locations for insulation displacement connectors (52a).

10. The communications connector (10) defined in Claim 3, wherein an amount of the localized increase in inductance is selected based at least in part on the amount of improvement the localized increase in inductance provides in the return loss associated with the first of the differential pairs.

11. The communications connector (10) defined in Claim 1, wherein the plurality of conductive paths (62a, 62b; 64a, 64b; 66a, 66b; 68a, 68b) are configured as differential pairs so that the at least one of the conductive paths (62a, 62b; 64a, 64b; 66a, 66b; 68a, 68b) is part of one of the differential pairs.

12. The communications connector (10) defined in Claim 11, wherein the localized increase in inductance is selected to provide an input impedance of approximately 100 ohms on the one of the differential pairs that includes the at least one of the conductive paths (62a) that includes two self-coupling sections (70, 72).

13. The communications connector (10) defined in Claim 11, wherein an amount of the localized increase in inductance is selected based at least in part on the amount of improvement the localized increase in inductance provides in the return loss associated with the one of the differential pairs that includes the at least one of the conductive paths (62a) that includes two self-coupling sections (70, 72).

## Patentansprüche

1. Kommunikationssteckverbinder (10), Folgendes umfassend.
mehrere Eingangsanschlüsse (22a, 22b; 24a, 24b; 26a, 26b; 28a, 28b); mehrere Ausgangsanschlüsse (42a, 42b; 44a, 44b; 46a, 46b; 48a, 48b); und
mehrere Leiterbahnen (62a, 62b; 64a, 64b; 66a, 66b; 68a, 68b), die jeweilige der mehreren Eingangsanschlüsse (22a, 22b); (24a, 24b; 26a, 26b; 28a, 28b) mit jeweiligen der mehreren Ausgangsanschlüsse (42a, 42b; 44a, 44b; 46a, 46b; 48a, 48b) verbinden;
wobei mindestens eine der Leiterbahnen (62a) zwei selbst anschließende Abschnitte (70, 72) umfasst, die unmittelbar aneinander angrenzen und dieselbe Momentanstromrichtung haben, so dass sich die Abschnitte selbst anschließen und einen lokalisierten Induktanzanstieg bewirken.

2. Kommunikationssteckverbinder (10) nach Anspruch 1, wobei es sich bei dem Kommunikationssteckverbinder (10) um einen Kommunikationsstecker (10) handelt, wobei der Stecker (10) einen Steckerrahmen (12) mit einer Stecköffnung (14) umfasst, und wobei die mehreren Eingangsanschlüsse (22a, 22b; 24a, 24b; 26a, 26b; 28a, 28b) mehrere Kontakte (22a, 22b; 24a, 24b; 26a, 26b; 28a, 28b) umfassen, die dazu ausgelegt sind, eine Passverbindung mit einem jeweiligen von mehreren Steckkontakten einzugehen, wenn ein Stecker in die Stecköffnung (14) eingesteckt wird, und wobei die mehreren Ausgangsanschlüsse (42a, 42b; 44a, 44b; 46a, 46b; 48a, 48b) mehrere Schneidklemmsteckverbinder (42a, 42b; 44a, 44b; 46a, 46b; 48a, 48b) umfassen, und wobei die mehreren Leiterbahnen (62a, 62b; 64a, 64b; 66a, 66b; 68a, 68b) mehrere Leiter (62a, 62b; 64a, 64b; 66a, 66b; 68a, 68b) umfassen, die auf einer dielektrischen Montageunterlage (20) montiert sind, wobei jeder Leiter (62a, 62b; 64a, 64b; 66a, 66b; 68a, 68b) einen jeweiligen Kontakt (22a, 22b; 24a, 24b; 26a, 26b; 28a, 28b) mit einem jeweiligen Schneidklemmsteckverbinder (42a, 42b; 44a, 44b; 46a, 46b; 48a, 48b) verbindet, wobei die zwei selbst anschließenden Abschnitte (70, 72) auf einem ersten der mehreren Leiter (62a) angeordnet werden.

3. Kommunikationssteckverbinder (10) nach Anspruch 2, wobei die mehreren Leiter (62a, 62b; 64a, 64b; 66a, 66b; 68a, 68b) als Differentialpaare von Leitern ausgelegt sind, und wobei ein zweiter der mehreren Leiter (62b), die zusammen mit dem ersten der mehreren Leiter (62a) ein erstes der Differentialpaare bildet, zwei selbst anschließende Abschnitte (78, 80) umfasst, die unmittelbar aneinander angrenzen und dieselbe Momentanstromrichtung haben, so dass sich die Abschnitte (78, 80) selbst anschließen und einen lokalisierten Induktanzanstieg bewirken.

4. Kommunikationssteckverbinder (10) nach Anspruch 3, wobei ein dritter und vierter der mehreren Leiter (66a, 66b), die ein zweites der Differentialpaare aufweisen, jeweils selbst anschließende Abschnitte (82, 84; 86, 88) umfassen, die unmittelbar aneinander angrenzen und dieselbe Momentanstromrichtung haben, so dass sich die Abschnitte (82, 84; 86, 88) selbst anschließen und einen lokalisierten Induktanzanstieg bewirken.

5. Kommunikationssteckverbinder (10) nach Anspruch 4, wobei der erste und zweite der mehreren Leiter (62a, 62b) elektrisch an jeweilige erste und zweite der mehreren Kontakte (22a, 22b) angeschlossen sind, die freie Enden haben, die aneinander angrenzen, und wobei der dritte und vierte der mehreren Leiter (66a, 66b) elektrisch an jeweilige dritte und vierte der mehreren Kontakte (26a, 26b) angeschlossen sind, die freie Enden haben, die die freien Enden des ersten und zweiten der mehreren Kontakte (22a, 22b) sandwichartig einschließen.

6. Kommunikationssteckverbinder (10) nach Anspruch 2, wobei die selbst anschließenden Abschnitte (70, 72) über ca. 0,05 und ca. 0,20 Zoll unmittelbar aneinander angrenzend verlaufen.

7. Kommunikationssteckverbinder (10) nach Anspruch 2, wobei ein Spalt zwischen den selbst anschließenden Abschnitten (70, 72) zwischen ca. 8 und ca. 15 Milli-Zoll beträgt.

8. Kommunikationssteckverbinder (10) nach Anspruch 2, wobei die selbst anschließenden Abschnitte (70, 72) einen lokalisierten Induktanzanstieg von zwischen ca. 2 und ca. 8 Nano-Henry bewirken.

9. Kommunikationssteckverbinder (10) nach Anspruch 2, wobei die zwei selbst anschließenden Abschnitte (70, 72) des ersten der mehreren Leiter (62) an eine der mehreren Montagestellen für Klemmschneidsteckverbinder (52a) angrenzen.

10. Kommunikationssteckverbinder (10) nach Anspruch 3, wobei ein Betrag des lokalisierten Induktanzanstiegs zumindest teilweise auf Grundlage des Betrags einer Verbesserung ausgewählt ist, die der lokalisierte Induktanzanstieg bei der mit dem ersten der Differentialpaare verbundenen Rückflussdämpfung bietet.

11. Kommunikationssteckverbinder (10) nach Anspruch 1, wobei die mehreren Leiterbahnen (62a, 62b; 64a, 64b; 66a, 66b; 68a, 68b) so als Differentialpaare ausgelegt sind, dass die mindestens eine der Leiterbahnen (62a, 62b; 64a, 64b; 66a, 66b; 68a, 68b) Teil eines der Differentialpaare ist.

12. Kommunikationssteckverbinder (10) nach Anspruch 11, wobei der lokalisierte Induktanzanstieg so ausgewählt ist, dass eine Eingangsimpedanz von ungefähr 100 Ohm in demjenigen der Differentialpaare bereitgestellt wird, das die mindestens eine der Leiterbahnen (62a) umfasst, die zwei selbst anschließende Abschnitte (70, 72) umfasst.

13. Kommunikationssteckverbinder (10) nach Anspruch 11, wobei ein Betrag des lokalisierten Induktanzanstiegs zumindest teilweise auf Grundlage des Betrags einer Verbesserung ausgewählt ist, die der lokalisierte Induktanzanstieg bei der mit dem einen der Differentialpaare verbundenen Rückflussdämpfung bietet, das die mindestens eine der Leiterbahnen (62a) umfasst, die zwei selbst anschließende Abschnitte (70, 72) umfasst.

## Revendications

1. Connecteur de communications (10) comprenant :
une pluralité de bornes d'entrée (22a, 22b ; 24a, 24b ; 26a, 26b ; 28a, 28b) ;
une pluralité de bornes de sortie (42a, 42b ; 44a, 44b ; 46a, 46b ; 48a, 48b) ; et
une pluralité de chemins conducteurs (62a, 62b ; 64a, 64b ; 66a, 66b ; 68a, 68b) qui connectent celles respectives de la pluralité de bornes d'entrée (22a, 22b ; 24a, 24b ; 26a, 26b ; 28a, 28b) à celles respectives de la pluralité de bornes de sortie (42a, 42b ; 44a, 44b ; 46a, 46b ; 48a, 48b) ;
dans lequel l'un au moins des chemins conducteurs (62a) comprend deux sections à auto-induction (70, 72) immédiatement contigües l'une par rapport à l'autre et présentant la même direction de courant instantané de telle sorte que les sections s'auto-induisent et provoquent un accroissement localisé de l'inductance.

2. Connecteur de communications (10) selon la revendication 1, dans lequel le connecteur (10) est une prise de communications (10), la prise (10) comprenant un corps de prise (12) présentant une ouverture de fiche (14), et dans lequel la pluralité de bornes d'entrée (22a, 22b ; 24a, 24b ; 26a, 26b ; 28a, 28b) comprend une pluralité de contacts (22a, 22b ; 24a, 24b ; 26a, 26b ; 28a, 28b) qui sont configurés pour s'accoupler à l'un respectif d'une pluralité de contacts de fiche lorsqu'une fiche est insérée dans l'ouverture de fiche (14), et dans lequel la pluralité de bornes de sortie (42a, 42b ; 44a, 44b ; 46a, 46b ; 48a, 48b) comprend une pluralité de connecteurs à déplacement d'isolant (42a, 42b ; 44a, 44b ; 46a, 46b ; 48a, 48b), et dans lequel la pluralité de chemins conducteurs (62a, 62b ; 64a, 64b ; 66a, 66b ; 68a, 68b) comprend une pluralité de conducteurs (62a, 62b ; 64a, 64b ; 66a, 66b ; 68a, 68b) montés sur un substrat de montage diélectrique (20), chaque conducteur (62a, 62b ; 64a, 64b ; 66a, 66b ; 68a, 68b) connectant un contact respectif (22a, 22b ; 24a, 24b ; 26a, 26b ; 28a, 28b) à un connecteur à déplacement d'isolant respectif (42a, 42b ; 44a, 44b ; 46a, 46b ; 48a, 48b), les deux sections à auto-induction (70, 72) étant situées sur un premier de la pluralité de conducteurs (62a).

3. Connecteur de communications (10) selon la revendication 2, dans lequel la pluralité de conducteurs (62a, 62b ; 64a, 64b ; 66a ; 66b ; 68a, 68b) sont configurés en tant que paires différentielles de conducteurs, et dans lequel un deuxième de la pluralité de conducteurs (62b), qui forme avec le premier de la pluralité de conducteurs (62a) une première des paires différentielles, comprend deux sections à auto-induction (78, 80) immédiatement contigües l'une par rapport à l'autre et présentant la même direction de courant instantané de telle sorte que les sections (78, 80) s'auto-induisent et provoquent un accroissement localisé de l'inductance.

4. Connecteur de communications (10) selon la revendication 3, dans lequel un troisième et un quatrième de la pluralité de conducteurs (66a, 66b) qui constituent une deuxième des paires différentielles, comprennent chacun des sections à auto-induction (82, 84 ; 86, 88) immédiatement contigües l'une par rapport à l'autre et présentant la même direction de courant instantané de telle sorte que les sections (82, 84 ; 86, 88) s'auto-induisent et provoquent un accroissement localisé de l'inductance.

5. Connecteur de communications (10) selon la revendication 4, dans lequel les premier et deuxième de la pluralité de conducteurs (62a, 62b) sont électriquement connectés aux premier et deuxième respectifs de la pluralité de contacts (22a, 22b) qui présentent des extrémités libres adjacentes l'une par rapport à l'autre, et dans lequel les troisième et quatrième de la pluralité de conducteurs (66a, 66b) sont électriquement connectés aux troisième et quatrième respectifs de la pluralité de contacts (26a, 26b) qui présentent des extrémités libres prenant en sandwich les extrémités libres des premier et deuxième de la pluralité de contacts (22a, 22b).

6. Connecteur de communications (10) selon la revendication 2, dans lequel les sections à auto-induction (70, 72) se déplacent de manière immédiatement adjacente l'une par rapport à l'autre sur une distance comprise entre 0,05 pouce environ et 0,20 pouce environ.

7. Connecteur de communications (10) selon la revendication 2, dans lequel un intervalle entre les sections à auto-induction (70, 72) est compris entre environ 8 millièmes de pouce et environ 15 millièmes de pouce.

8. Connecteur de communications (10) selon la revendication 2, dans lequel les sections à auto-induction (70, 72) provoquent un accroissement localisé de l'inductance compris entre environ 2 nanohenrys et environ 8 nanohenrys.

9. Connecteur de communications (10) selon la revendication 2, dans lequel les deux sections à auto-induction (70, 72) du premier de la pluralité de conducteurs 62a sont adjacentes à l'un de la pluralité d'emplacements de montage des connecteurs à déplacement d'isolant (52a).

10. Connecteur de communications (10) selon la revendication 3, dans lequel une quantité de l'accroissement localisé de l'inductance est sélectionnée sur la base, en partie au moins, de la quantité d'amélioration que l'accroissement localisé de l'inductance apporte dans l'affaiblissement de réflexion associé à la première des paires différentielles.

11. Connecteur de communications (10) selon la revendication 1, dans lequel la pluralité de chemins conducteurs (62a, 62b ; 64a, 64b ; 66a, 66b ; 68a, 68b) sont configurés en tant que paires différentielles de telle sorte que l'un au moins des chemins conducteurs (62a, 62b ; 64a, 64b ; 66a ; 66b ; 68a, 68b) fasse partie de l'une des paires différentielles.

12. Connecteur de communications (10) selon la revendication 11, dans lequel l'accroissement localisé de l'inductance est sélectionné pour fournir une impédance d'entrée approximativement égale à 100 ohms sur celle des paires différentielles qui comprend l'un au moins des chemins conducteurs (62a) qui comprennent deux sections à auto-induction (70, 72).

13. Connecteur de communications (10) selon la revendication 11, dans lequel une quantité de l'accroissement localisé de l'inductance est sélectionnée sur la base, en partie au moins, de la quantité d'amélioration que l'accroissement localisé de l'inductance apporte dans l'affaiblissement de réflexion associé à celle des paires différentielles qui comprend l'un au moins des chemins conducteurs (62a) qui comprennent deux sections à auto-induction (70, 72).
